(19) **Europäisches Patentamt**

**European Patent Office**

**Office européen des brevets**

(11) **EP 1 026 546 B1**

(12) **EUROPEAN PATENT SPECIFICATION**

(45) Date of publication and mention
of the grant of the patent:
**31.07.2002 Bulletin 2002/31**

(51) Int Cl.[7]: **G03F 7/00**, G03H 1/02

(21) Application number: **99309584.3**

(22) Date of filing: **30.11.1999**

(54) **Process for holography**

Holographisches Verfahren

Procédé holographique

(84) Designated Contracting States:
**DE FR GB**

(30) Priority: **07.12.1998 US 206441**

(43) Date of publication of application:
**09.08.2000 Bulletin 2000/32**

(73) Proprietor: **LUCENT TECHNOLOGIES INC.**
**Murray Hill, New Jersey 07974-0636 (US)**

(72) Inventors:
  • **Chandross, Edwin Arthur**
    **Murray Hill, New Jersey 07974 (US)**
  • **Dhar, Lisa**
    **New Providence, New Jersey 07974 (US)**
  • **Galvin-Donoghue, Mary Ellen**
    **Titusville, New Jersey 08560 (US)**
  • **Lowe-Harris, Alexander**
    **Maplewood, New Jersey 07040 (US)**
  • **Patel, Sanjay**
    **New Providence, New Jersey 07974 (US)**
  • **Schilling, Marcia Lea**
    **Basking Ridge, New Jersey 07920 (US)**
  • **Schnoes, Melinda Lamont**
    **South Amboy, New Jersey 08879 (US)**
  • **Wiltzius, Pierre**
    **Millington, New Jersey 07946 (US)**

(74) Representative:
**Buckley, Christopher Simon Thirsk et al**
**Lucent Technologies (UK) Ltd,**
**5 Mornington Road**
**Woodford Green, Essex IG8 0TU (GB)**

(56) References cited:
**EP-A- 0 353 864          EP-A- 0 824 222**
**US-A- 4 187 111          US-A- 4 842 968**

**Description**

BACKGROUND OF THE INVENTION

Field of the Invention

The invention relates to holographic recording media, in particular media useful with holographic storage systems, or useful as components such as optical filters or beam steerers.

Discussion of the Related Art

Developers of information storage devices and methods continue to seek increased storage capacity. As part of this development, so-called page-wise memory systems, in particular holographic systems, have been suggested as alternatives to conventional memory devices. Page-wise systems involve the storage and readout of a representation, e.g., a page, of data. Typically, recording light passes through a two-dimensional array of dark and transparent areas representing data, and the holographic system stores, in three dimensions, holographic representations of the pages as patterns of varying refractive index in a storage medium. Holographic systems are discussed generally in D. Psaltis et al., "Holographic Memories," Scientific American, November 1995. One method of holographic storage is phase correlation multiplex holography, which is described in U.S. Patent No. 5,719,691 issued February 17, 1998.

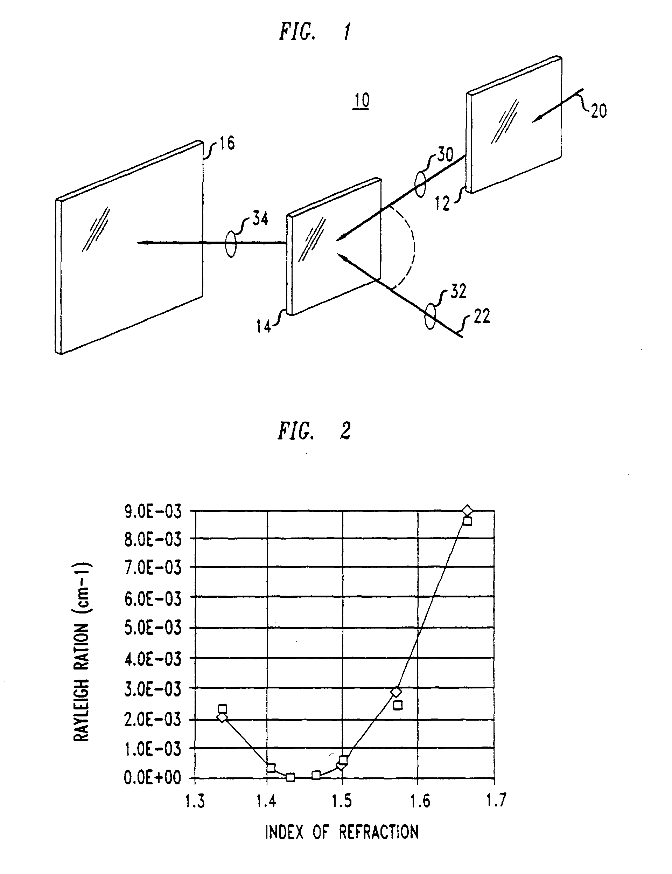

Fig. 1 illustrates the basic components of a holographic system 10. System 10 contains a modulating device 12, a photorecording medium 14, and a sensor 16. Modulating device 12 is any device capable of optically representing data in two-dimensions. Device 12 is typically a spatial light modulator that is attached to an encoding unit which encodes data onto the modulator. Based on the encoding, device 12 selectively passes or blocks portions of a signal beam 20 passing through device 12. In this manner, beam 20 is encoded with a data image. The image is stored by interfering the encoded signal beam 20 with a reference beam 22 at a location on or within photorecording medium 14. The interference creates an interference pattern (or hologram) that is captured within medium 14 as a pattern of, for example, varying refractive index. It is possible for more than one holographic image to be stored at a single location and/or for holograms to be stored in overlapping positions, by, for example, varying the angle, the wavelength, or the phase of the reference beam 22, depending on the particular reference beam employed. Signal beam 20 typically passes through lens 30 before being intersected with reference beam 22 in the medium 14. It is possible for reference beam 22 to pass through lens 32 before this intersection. Once data is stored in medium 14, it is possible to retrieve the data by intersecting reference beam 22 with medium 14 at the same location and at the same angle, wavelength, or phase (depending on the multiplexing scheme used) at which reference beam 22 was directed during storage of the data. The reconstructed data passes through lens 34 and is detected by sensor 16. Sensor 16 is, for example, a charged coupled device or an active pixel sensor. Sensor 16 typically is attached to a unit that decodes the data. It is possible to use volume holograms as passive optical components to control or modify light directed at the medium, e.g., filters or beam steerers.

The capabilities of such holographic storage systems are limited in part by the storage media. Iron-doped lithium niobate has been used as a storage medium for research purposes for many years. However, lithium niobate is expensive, is poor in sensitivity (1 J/cm$^2$), has relatively low index contrast ($\Delta$n of about $10^{-4}$), and exhibits destructive read-out (i.e., images are destroyed upon reading). Alternatives have therefore been sought, particularly in the area of photosensitive polymer films. See, e.g., Selected Papers on Holographic Recording, H.J. Bjelkagen, ed., SPIE Press, Vol. MS 130 (1996). The materials described in this set of articles generally contain a photoimageable system containing a liquid monomer material (the photoactive monomer) and a photoinitiator (which promotes the polymerization of the monomer upon exposure to light), where the photoimageable material system is located within an organic polymer host matrix that is substantially inert to the exposure light. During writing of information into the material by exposure to radiation in selected areas, the monomer polymerizes in the exposed regions. Due to the lowering of the monomer concentration caused by induced polymerization, monomer from the dark, unexposed regions of the material diffuses to the exposed regions. The polymerization and resulting concentration gradient create a refractive index change, forming the hologram representing the data. Typically, the system is then fixed by a flood cure exposure, which destroys any remaining photosensitivity in the medium. (For further discussion of the recording mechanism, see "Organic Photochemical Refractive Index Image Recording Systems" in Advances in Photochemistry, Vol. 12, John Wiley & Sons (1980).) Most holographic systems of this type are based on photopolymerization of free-radical photoactive monomers such as acrylate esters. See, for example, U.S. patent application serial no. 08/698,142 (our reference Colvin-Harris-Katz-Schilling 1-2-16-10).

While such photopolymer systems provide useful results, they exhibit changes in dimension due to shrinkage induced by polymerization of the photactive monomers. Dimensional changes are also caused by thermal expansion. (Typical linear coefficient of thermal expansion values for these systems range from about 100 to about 300 ppm/°C.)

These dimensional changes, while small, tend to distort the recorded holographic gratings, degrade the fidelity with which data is capable of being recovered, and thereby limit the density of data which the polymer is able to support. (One particular problem caused by dimensional change is Bragg detuning, which is the shift of the Bragg angle of a plane-wave volume holographic grating. The magnitude of the Bragg detuning is typically determined by the extent to which a reference beam must be rotated from the original recording position in order to attain the maximum diffraction efficiency from the hologram.) Some attempts to overcome these dimensional changes have led to experimentation with porous glass matrices containing a photoimageable system. See, e.g., U.S. Patents Nos. 4,842,968 and 4,187,111; V.I. Sukhanov et al., "Sol-Gel Porous Glass as Holographic Medium," Journal of Sol-Gel Science and Technology, Vol. 8, 1111 (1997); S.A. Kuchinskii, "Principles of hologram formation in capillary composites," Opt. Spectrosc., Vol. 72, No. 3, 383 (1992); S. A. Kuchinskii, "The Principles of Hologram Formation in Capillary Composites," Laser Physics, Vol. 3, No. 6, 1114 (1993); V.I. Sukhanov, "Heterogeneous recording media," Three-Dimensional Holography: Science, Culture, Education, SPIE Vol. 1238, 226 (1989); V.I. Sukhanov, "Porous glass as a storage medium," Optica Applicata, Vol. XXIV, No. 1-2, 13 (1994); and J.E. Ludman et al., "Very thick holographic nonspatial filtering of laser beams," Opt. Eng., Vol. 36, No. 6, 1700 (1997).

U.S. Patent No. 4,842,968, for example, discloses a process in which a porous glass matrix is immersed in a photoimageable system, such that the photoimageable system diffuses into the open pores of the matrix. After exposure to light, the unexposed, i.e., non-polymerized, portions of the photoimageable system must be removed from the pores with a solvent. Typically, a different material offering desirable refractive index contrast is then introduced into the emptied pores. It is only after these steps that a readable hologram formed. (While the initial irradiation step tended to form a latent image in these previous matrix-based media, the latent image could not be read non-destructively by the same wavelength of light used for recordation, i.e., the reference beam could not be used for readout. Thus, no hologram was considered to have been formed. As used herein, the term readable hologram indicates a pattern capable of being non-destructively read by the same wavelength of light used for recordation.)

While glass matrices offer desirable rigidity and structural integrity, as well as formation of relatively thick, e. g., greater than 1mm, media, the '968 patent illustrates several practical drawbacks encountered in such matrix-based recording media. Specifically, complex chemical treatments with solvents are required after exposure to remove reacted or unreacted material in order to attain a readable hologram. These treatments are undesirable from a commercial usability standpoint, and also tend to cause unwanted non-uniformity in the material. Also, previous studies with porous glass matrices have generally focused on recordation of a single hologram, and have not demonstrated the viability of recording multiple holograms, e.g., the studies have not indicated the extent of Bragg detuning that occurs upon readout of multiple recorded holograms.

The reader is referred to EP-A- 353 864 which discloses a technique for forming an optical element. The medium is a porous glass having photosensitive monomer therein. The glass is exposed to locally polymerise the monomer, and then any unexposed monomer is either removed, or sealed in the medium.

## SUMMARY OF THE INVENTION

A process in accordance with the invention is defined in claim 1. In contrast to some previous media containing porous matrices, the invention allows readable holograms to be formed in a medium without the need for solvent processing steps subsequent to writing. Due to the rigid nature of the matrix, examples may be obtained in which polymerization and/or diffusion during formation of each individual hologram induces only a small level of Bragg detuning, e.g., causes only inconsequential changes in the usability of previously-recorded holograms. Temperature fluctuations similarly may induce only small levels of Bragg detuning. Improved archival life of recorded holograms and improved fidelity of read-out, as well as improved optical components such as beam steerers, may be attained. In addition, the matrix containing the photoimageable system typically exhibits low light scattering, both before hologram formation as well as after hologram formation and any subsequent fixing step. The low light scattering reduces the level of noise introduced by scattered light during readout, such noise undesirably degrading the fidelity with which data is recovered.

(Rigid indicates that a matrix having a photoimageable system in its pores exhibits an absolute Bragg shift of less than 0.1° for all plane-wave gratings with absolute grating tilt angles less than 25°. The shifts are measured by recording weak holograms (diffraction efficiencies less than 0.01%) in blank media, consuming substantially all remaining photopolymerizable groups in the photoimageable system, and measuring the rotation in the Bragg angles of the holograms relative to the original recording positions. The geometry of an experiment used to measure the Bragg shift in this manner is presented in L. Dhar et al., "Temperature-induced changes in photopolymer volume holograms," Applied Physics Letters, Vol. 73 No. 10, 1337 (1998). Grating tilt angles are defined as (90 - $\phi$) where $\phi$ is defined as in Dhar et al., supra. Rigid further indicates that the absolute changes in the Bragg angles with temperature for all plane-wave gratings with absolute grating tilt angles less than 25° are less than 0.006°/°C. Solvent processing indicates introduction of one or more liquid reagents into the porous matrix after the photoimageable system has been introduced, in order to induce changes in the physical or chemical character of the photoimageable system. Low light scattering indicates a Rayleigh ratio in 90° light scattering of a wavelength used for hologram formation ($R_{90°}$) less than about 7 $\times$ $10^{-3}$. The Rayleigh ratio ($R_\theta$) is a conventionally known property, and is defined as the energy scattered by a unit volume in the direction θ, per steradian, when a medium is illuminated with a unit intensity of unpolarized light, as discussed in M. Kerker, <u>The Scattering of Light and Other Electromagnetic Radiation,</u> Academic Press, 1969, 38. The Rayleigh ratio is typically obtained by comparison to the energy scattered by a reference material having a known Rayleigh ratio.)

The matrix is generally a porous glass containing from about 10 vol.% to about 50 vol.% interconnected (or open) porosity. A typical number is about 30 vol.% interconnected porosity. The interconnected pores allow introduction of the photoimageable system throughout the matrix material, and also allow diffusion to occur between pores. The level of porosity, pore size, and thickness, among other things, are capable of varying widely depending on the matrix material and the photoimageable system, as long as the filled matrix exhibits acceptable properties. The area of a surface of the matrix (i.e., the area of the top or bottom surface) is generally at least 6.45 $cm^2$ (1 $in^2$), and the thickness of the matrix is typically at least 200 μm, optionally at least 500 μm. The photoimageable system contains one or more photopolymerizable components, e.g., photoactive monomers or oligomers that polymerize in response to radiation to form a hologram. Optionally, additives are included in the photoimageable system to perform various functions, such as photoinitiator, diffusion agents, or additional oligomeric or polymeric materials. Lower viscosity in the photoimageable system eases the process of filling the pores.

In one embodiment, a rigid, porous silica glass matrix is provided with a photoimageable system containing poly(ethyleneglycol) diacrylate oligomer and di(ethyleneglycol) ethyl ether acrylate monomer, along with a photoinitiator. The photoimageable system-containing matrix is placed between two glass slides, and precured by exposure to light to polymerize a portion of the oligomer and/or monomer. Multiple holograms are subsequently written in the medium by, for example, angle multiplexing, and a flood cure is then performed to fix the holograms, i.e., to consume any remaining photopolymerizable groups. The holograms are then capable of being read without the need for any solvent processing, and exhibit low Bragg detuning.

The invention therefore provides an improved recording medium containing a photoimageable system-containing rigid matrix, in which multiple holograms are capable of being formed without the need for solvent processes, and where the holograms exhibit desirable properties.

BRIEF DESCRIPTION OF THE DRAWINGS

Fig. 1 shows the basic elements of a holographic storage system.

Fig. 2 shows the effect of various filler materials on the light scattering properties of a filled porous material.

Figs. 3A and 3B show, respectively, an angular scan of diffraction efficiencies of multiple holograms recorded according to the invention, and a Bragg peak of one such hologram.

Fig. 4 shows the M# of a medium of the invention, plotted as a function of cumulative exposure time.

Fig. 5 shows the angular deviation for multiple holograms recorded according to the invention.

Figs. 6A and 6B show, respectively, the intensity profile of a data array imaged through a medium of the invention, and a histogram of the measured intensities.

Fig. 7 shows shifts in the Bragg angles of holograms stored in a medium of the invention and then read at different temperatures.

Figs. 8A and 8B show, respectively, the same data of Fig. 7, but with a different scale. The shifts in Bragg angles for various sample temperatures are shown for a conventional photopolymer medium and for a medium of the invention.

DETAILED DESCRIPTION OF THE INVENTION

According to the invention, a recording medium contains a rigid, porous matrix, the pores containing a photoimageable system. Due to the rigid nature of the matrix, polymerization and/or diffusion during formation of each individual hologram induces only a small level of Bragg detuning, e.g., causes only inconsequential changes in the usability of previously-recorded holograms. Temperature fluctuations similarly induce only a small Bragg shift. Advantageously, the photoimageable system-containing matrix also exhibits low light scattering, both before hologram formation as well as after hologram formation and any subsequent fixing step, since scattering interferes with writing and readout. The matrix generally contains from about 10 vol.% to about 50 vol.% interconnected porosity. A typical number is about 30 vol.% interconnected porosity. The interconnected pores allow introduction of the photoimageable system throughout the matrix material, and also allow diffusion to occur between pores. The volume percent porosity, pore size, and thickness, among other things, are capable of varying widely depending on the matrix material and the photoimageable system, as long as the filled matrix exhibits acceptable properties. The area of a surface of the matrix is generally at least 6.45 cm$^2$ (1 in$^2$), and the thickness of the matrix is typically at least 200 μm, optionally at least 500 μm.

Typically, the matrix is a porous glass. Porous glass materials suitable for the invention are discussed generally in T. Elmer, "Porous and Reconstructed Glasses," Engineered Materials Handbook, Vol. 4: Ceramics and Glasses, ASM International, 427, 1992. One useful matrix material is Vycor® brand glasses, available from Corning Glass. Other materials exhibiting the desired porosity, rigidity and light scattering properties are also suitable. A variety of surface preparations or treatments are possible. In porous glass received from vendors, water tends to be found at the surface of the matrix material, and such water is able to be removed by drying. It is then possible to make the surfaces of the matrix material hydrophobic, such as by silylation (see, e.g., E.P. Plueddemann, Silane Coupling Agents, Plenum Press (1991)), in order to inhibit water from returning to the matrix surface. Other treatments to prevent or reduce interference with polymerization in the photoimageable system will be apparent to one skilled in the art.

The photoimageable system contains one or more photopolymerizable components, e.g., photoactive monomers or oligomers, along with optional additives such as photoinitiator, diffusion agents, or additional oligomeric or polymeric materials. Lower viscosity in the photoimageable system eases the process of filling the pores. However, while consideration should be given to the viscosity of the photoimageable system, the primary concern is the overall holographic properties.

The photopolymerizable component is one or more monomers and/or oligomers capable of undergoing photoinitiated polymerization such that a hologram is formed. Photoactive monomers which polymerize by a free-radical reaction are generally suitable, including, but not limited to molecules containing ethylenic unsaturation such as acrylates, methacrylates, styrene, substituted styrenes, vinylnaphthalene, substituted vinylnaphthalenes, and other reactive vinyl derivatives. Free-radical copolymerizable pair systems, such as vinyl ether mixed with maleate, are also suitable.

Advantageously, the photopolymerizable component is acrylate-based, advantageously with a polyether backbone. Two such acrylate-based components are poly(ethyleneglycol) diacrylate oligomer and di(ethyleneglycol) ethyl ether acrylate monomer. A photoimageable system containing a mixture of this oligomer and monomer has been found to be useful. The relatively flexible polyether backbones provide relatively low Tg, which, as mentioned above, is believed to contribute to eased diffusion. The mixture also exhibits relatively low viscosity, which eases filling of matrix pores. Other oligomers and monomers having like characteristics are expected to be similarly useful in the invention.

In addition to the photoactive monomer, the photoimageable system typically contains a photoinitiator. The photoinitiator, upon exposure to relatively low levels of the recording light, chemically initiates the polymerization of the photopolymerizable component, avoiding the need for direct light-induced polymerization. The photoinitiator generally should offer a source of species that initiate polymerization of the particular photopolymerizable component. Typically, 0.1 to 5 wt.% photoinitiator, based on the weight of the photoimageable system, provides desirable results.

A variety of photoinitiators known to those skilled in the art and available commercially are suitable for use in the invention. It is advantageous to use a photoinitiator that is sensitive to light in the visible part of the spectrum, particularly at wavelengths available from conventional laser sources, e.g., the blue and green lines of Ar$^+$ (458, 488, 514 nm) and He-Cd lasers (442 nm), the green line of frequency doubled YAG lasers (532 nm), and the red lines of He-Ne (633 nm) and Kr$^+$ lasers (647 and 676 nm). One advantageous free radical photoinitiator is bis(η-5-2,4-cyclopentadien-1-yl)bis[2,6-difluoro-3-(1H-pyrrol-1-yl)phenyl]titanium, available commercially from Ciba Specialty Chemicals as CGI-784. Free-radical photoinitiators of dye-hydrogen donor systems are also possible. Examples of suitable dyes include eosin, rose bengal, erythrosine, and methylene blue, and suitable hydrogen donors include tertiary amines such as n-methyl diethanol amine.

It is also possible to use other additives in the photoimageable system, e.g., inert diffusing agents having relatively high or low refractive indices or photoactive components designed to improve refractive index contrast. It is possible, however, that such additives will perform differently in the medium of the invention, as opposed to a conventional photopolymer medium, due to the unique nature of the porous matrix. Control samples are easily prepared to determine the actual effects of such additives.

In accordance with the guidelines provided herein, it is possible to prepare control samples to determine whether components in a photoimageable system provide certain desired storage characteristics, as well as to determine what matrix/photoimageable system combinations provide the rigidity and low light scattering discussed above. Factors relating to selection of materials that provide low light scattering are reflected in Example 1 below.

It is possible to dispose the photoimageable system into the pores of the matrix by conventional techniques. Typically, the matrix is immersed in the photoimageable system and soaked for a length of time sufficient to adequately fill the pores, advantageously in a uniform manner throughout the thickness of the matrix. Generally, pores are substantially filled with the photoimageable system. Adequate filling of the pores in important in maintaining light scattering at an acceptably low level. Specifically, because polymerization induces shrinkage, irradiation of an inadequately-filled matrix will lead to formation of pockets or voids that lead to increased light scattering in the matrix. It is also possible to use a vacuum filling technique, in which the air is drawn from the pores by placing the matrix under vacuum, and the matrix is then immersed directly in the photoimageable system without exposure to atmospheric pressure. Such vacuum filling is expected to increase the rate of filling. Control runs are easily performed to determine an appropriate soak time for a desired extent of filling.

Typically, the photoimageable system-containing matrix is placed between two glass or plastic sheets to preserve the optical quality of the overall medium, and to reduce oxygen inhibition of polymerization at the surface of the matrix. It is possible to use an apparatus containing mounts, e.g. vacuum chucks, to hold the sheets, these mounts capable of being adjusted in response to changes in parallelism and/or spacing of the substrates. In such an apparatus, it is possible to monitor the parallelism of the substrates in real-time by use of a conventional interferometric method, and make any necessary adjustments during the cure. Such a method is discussed, for example, in U.S. patent application serial no. 08/867,563 (our reference Campbell-Harris-Levinos 3-5-3). It is also possible to place a filler material between the matrix surface and such glass or plastic sheets, where the filler material is selected to maintain desired optical properties, such as optical flatness.

Optionally, a pre-cure is performed to polymerize a portion of the photopolymerizable components of the photoimageable system. For example, for a photoimageable system containing a 3:2 weight ratio of poly(ethyleneglycol) oligomer diacrylate and di(ethyleneglycol) ethyl ether acrylate monomer, a precure is typically provided such that greater than 70% of the photopolymerizable components are reacted (i.e., polymerized), as measured by a technique such as near-infrared spectroscopy. Such a precure is capable of being performed by any conventional method, e.g., by use of a mercury lamp with appropriate spectral filtering.

The medium of the invention is then capable of being used for storage of holograms, e.g., in a system such as discussed previously. Typically, after formation of readable holograms in the medium, the holograms are fixed in the medium, e.g., by a flood cure to consume any remaining photopolymerizable groups, such that permanent, readable holograms are formed (permanent indicating that substantially no photosensitivity remains in the medium).

Readable holograms according to the invention include holograms formed to provide passive optical components that control or modify light directed at the hologram. Examples of such holographic optical elements are beam filters, beam steerers or deflectors, and optical couplers. (See, e.g., L. Solymar and D. Cooke, Volume Holography and Volume Gratings, Academic Press, 315-327 (1981).) A beam filter separates part of an incident laser beam that is traveling along a particular angle from the rest of the beam. Specifically, the Bragg selectivity of a thick transmission hologram is able to selectively diffract light along a particular angle of incidence, while light along other angle travels undeflected through the hologram. (See, e.g., J.E. Ludman et al., "Very thick holographic nonspatial filtering of laser beams," Optical Engineering, Vol. 36, No. 6, 1700 (1997). A beam steerer is a hologram that deflects light incident at the Bragg angle. An optical coupler is typically a combination of beam deflectors that steer light from a source to a target. These holographic optical elements are fabricated by imaging a particular optical interference pattern within a recording medium, as discussed previously. Because distortions of the recording medium tend to degrade the performance of an optical element, the rigid medium of the invention provides optical elements having desirable properties.

The invention will be further clarified by the following examples, which are intended to be exemplary.


**Light Scattering**


Example 1

Porous Vycor® 7930 glass samples were obtained from Corning Glass, having been previously cleaned by the process outline in Corning's product information sheet (PI-VPG-91). The samples were cylindrical, approximately 1 cm in diameter and 1.5 cm long. According to the product specifications, the glass had a nominal pore diameter of 40 Å with a pore size distribution of $\pm 3$ Å and about 30% interconnected porosity. No special care was taken to avoid adsorption of contaminants from the ambient air, and the samples had a slightly yellowish tint, indicative of some contaminant adsorption. The samples were filled with seven different liquids, reflected in Table 1, having indexes of refraction spanning the Vycor's index of 1.458 (see T. Elmer, "Porous and Reconstructed Glasses," supra). The time required for the liquids to substantially fill the samples ranged from hours to days, depending on the viscosity of the liquids, the wettability of the internal glass surface by the liquids, and the solubility of air in the fluids (because air must leave the internal pore volume by dissolving in the liquid under capillary pressure).

The light source for the scattering experiments was an Argon ion laser ($\lambda$=488 nm), 10 mW incident power. The scattered light was collected at an angle of 90° with a photomultiplier. Since the spatial fluctuations in these samples are much smaller than the wavelength of the light, the scattering is isotropic. Care was taken to avoid spurious stray reflections and scattering from cell walls. The 488 nm filter was placed before the collection optics to reject the fluorescent light emitted by impurities. As a reference, a filtered toluene sample was measured, and the known Rayleigh ratio of toluene, $18.4 \times 10^{-6}$ cm$^{-1}$, allowed conversion of the measured intensities to absolute units.

Table 1

| Sample | Index of Refraction (at 488 nm) | Rayleigh Ratio $(cm^{-1})$ | Fraction of Scattered Light Collected by f1 optics |
|---|---|---|---|
| Water in Vycor | 1.338 | 2.43E-03 | 3.60E-05 |
| Octane in Vycor | ' 1.403 | 4.11E-04 | 6.08E-06 |
| Cyclohexane in Vycor | 1.429 | 9.29E-05 | 1.37E-06 |
| Carbon tetrachloride in Vycor | 1.464 | 1.43E-04 | 2.12E-06 |
| Toluene in Vycor | 1.499 | 6.61E-04 | 9.78E-06 |
| Benzyl benzoate in Vycor | 1.573 | 2.50E-03 | 3.70E-05 |
| Phenylnaphthalene in Vycor | 1.669 | 8.56E-03 | 1.27E-04 |
| Toluene | N/A | 1.84E-05 | 2.72E-07 |

Fig. 2 shows, as squares, the data of Table 1.

In addition, the data of Table 1 are well described by:

$$R = R_0 \left(n_{vycor} - n_{liquid}\right)^2 + R_B,$$

where

$n_{vycor}$ is a fit value for the index of refraction of Vycor,
$R_0$ is a constant amplitude, and
$R_B$ is a small background.

The best fit values for these parameters are $n_{vycor}$ = 1.437, Ro = 0.179, and $R_B$ = 5.4 $\times$ $10^{-5}$. Figure 2 shows as diamonds the calculated Rayleigh ratios using these parameters, with the diamonds connected by solid lines.

**Holography**

Experimental Methods:

Photoimageable system

The photoimageable system contained poly(ethyleneglycol) oligomer diacrylate, obtained from Aldrich and having an average $M_n$ of about 575, and di(ethyleneglycol) ethyl ether acrylate monomer, also obtained from Aldrich, in a 3:2 oligomer:monomer weight ratio, along with 1 wt.% of a visible photoinitiator - CGI-784, obtained from Ciba Specialty Chemicals. The photoimageable system exhibited a viscosity of 0.17 Poise ($\pm$10%) at a shear rate of 100 reciprocal seconds and 25°C.

Sample Preparation

The porous glass was Vycor® 7930 obtained from Corning Glass, having a nominal pore diameter of 40 Å with a pore size distribution of $\pm$3 Å and about 30% interconnected porosity (according to the specification sheet). Sheets of the glass having a size of 10.16cm x 10.16cm x 0.16cm (4" x 4" x 1/16") were ground and polished before the step of etching the pores (see T. Elmer, "Porous and Reconstructed Glasses," supra). The sheets were cut into pieces approximately 1.02cm (0.4") square and used without cleaning. These glass pieces were then immersed in the photoimageable system for at least two weeks to provide substantially complete and uniform filling of the pores through the thickness of the glass. The filled glass pieces were then placed onto a glass microscope slide and covered with a microscope cover slip. These media were then pre-cured to greater than 70% by exposure to a mercury lamp filtered to transmit light at about 10 mW/cm$^2$ over wavelengths longer than 530 nm. (The extent of cure was measured by near-infrared spectroscopy.)

### Holographic recording

The recording source was a diode-pumped frequency-doubled Nd:YAG laser providing light at 532 nm. The light was spatially filtered and collimated to produce a plane-wave beam. The light was split between two arms of an interferometer by half-wave plates and a polarizing beam splitter. The beams intersected at the recording plane at an angle of 44° (external to the sample). Holograms were angle multiplexed by rotation of the sample. After recording of the holograms, the sample was flood cured with a xenon lamp filtered to transmit light at a wavelength longer than 530 nm, in order to consume any remaining unreacted species. The holograms were read by blocking one arm of the interferometer and recording the intensity of the light transmitted and diffracted by the other arm as the sample was rotated. (The rotation step size was 0.003°.) The diffraction efficiencies of the holograms were calculated by taking the ratio of the intensity of the diffracted light to the sum of the intensities of the diffracted and transmitted light.

### Example 2

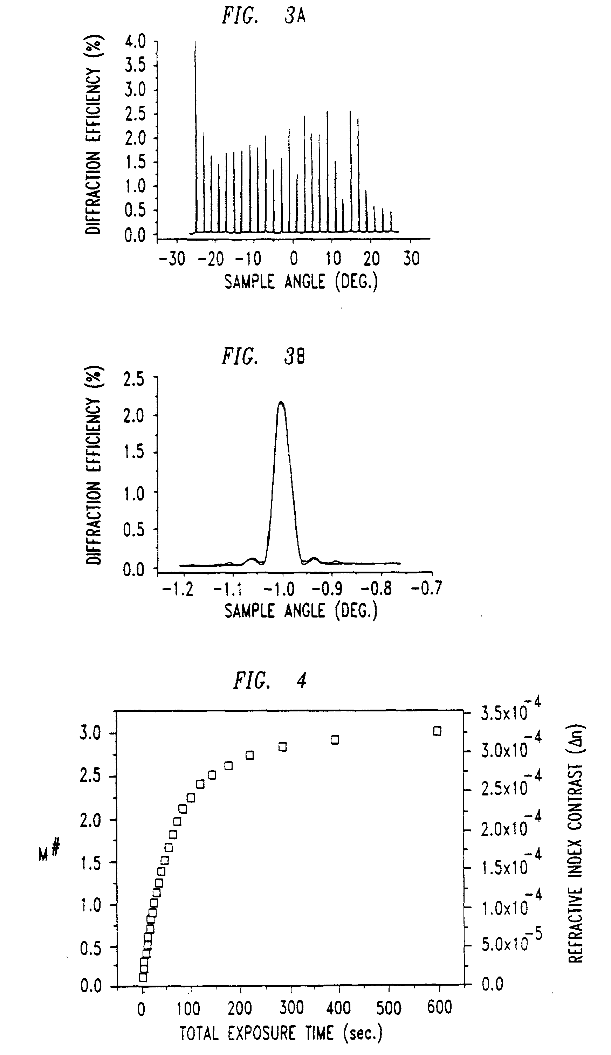

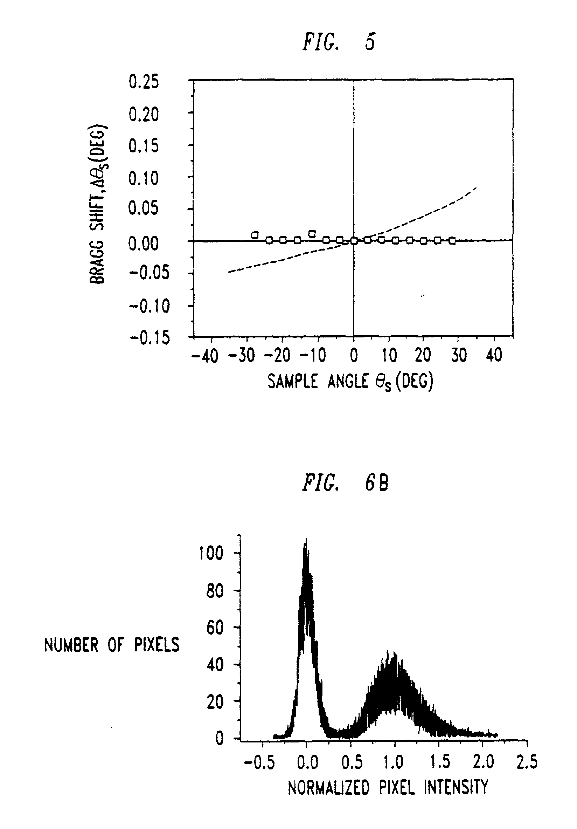

To measure dynamic range, 26 holograms were angle multiplexed with an angular separation of 2°, from a sample angle of -25° to 25°. The sample angle is defined as the angle between the normal to the sample and the bisector of the recording arms. (The angular separation of the recording arms was 44° measured in air.) An angular scan of the diffraction efficiencies of the 26 holograms is shown in Fig. 3A. Fig. 3B shows an enlarged view of the Bragg peak recorded at a sample angle of - 1°, along with a comparison to the best fit to the data using Kogelnik's coupled wave theory (H. Kogelnik, "Couple Wave Theory for Thick Hologram Gratings," The Bell System Technical Journal, Vol. 48, No. 9, 2909 (1969)). The data were fit by utilizing equation (43) of the reference, with the known refractive index of the material, the angular separation between the recording arms, the sample angle, and the recording and reading wavelengths. Only the value of the thickness of the medium was allowed to vary to obtain the best fit to the data.
The dynamic range of the recording material was calculated from the diffraction efficiencies. The M# (i.e., the sum of the square roots of the diffraction efficiencies of the multiplexed holograms) is plotted as a function of cumulative exposure time in Fig. 4.

### Example 3

To measure the effective dimensional stability of the media, 15 relatively weak holograms (i.e., having diffraction efficiencies less than 0.1%) were angle multiplexed with an angular separation of 4°, with the sample angle varying from -28° to 28°. The angular deviation, i.e., the difference between the sample angle at which each hologram was recorded and the sample angle at which the maximum diffraction efficiency for each hologram was measured, is shown as a solid line in Fig. 5. The angular deviation for the recorded holograms was negligible, i.e., within the error of the measurement technique, demonstrating the high dimensional stability of the recording medium. As a comparison, Fig. 5 also shows, as a dashed line, the angular deviation expected from a material exhibiting 0.1% transverse shrinkage and a change in bulk refractive index of $9 \times 10^{-4}$. The Bragg detuning exhibited by the comparative model system is what would be expected for the glass-polymer system of the invention if the matrix did not provide the rigidity to withstand the shrinkage of the resin within its pores.

### Example 4

To prepare media for this example, two 1.1 mm thick glass sheets were placed in an apparatus containing mounts, e.g. vacuum chucks, capable of being adjusted in response to changes in parallelism and/or spacing of the sheets. A photoimageable system-filled matrix, made by a process as described in the experimental methods section, was mounted between the sheets using additional photoimageable system as an adhesive to mount the filled matrix securely.
The optical system was the same as used in Examples 2 and 3. The intensity profile of a data array imaged through the medium and through the optical train of the signal arm, and recorded by a charge-coupled device detector is shown in Fig. 6A. Each pixel of the data array was mapped onto a corresponding pixel of the detector array. The intensity profile was analyzed by plotting a histogram of the intensities of the pixels captured by the detector, and this histogram is shown in Fig. 6B.
The extent of overlap between (a) the intensity distribution centered around the intensities of the pixels that block the light and (b) the distribution centered around the pixels that pass the light was used to calculate the probability of detecting imaging errors. This calculated probability was well below (i.e., better than) the limit required to insure error-free recovery.

Example 5

The effects of changes in temperature on volume holograms written in the medium of the invention were measured. The sample used for the experiments was made by a process as described in the experimental methods section. A 0.0076 cm (0.003") gauge thermocouple was attached to the matrix during the pre-cure to provide an accurate measure of the sample temperature.

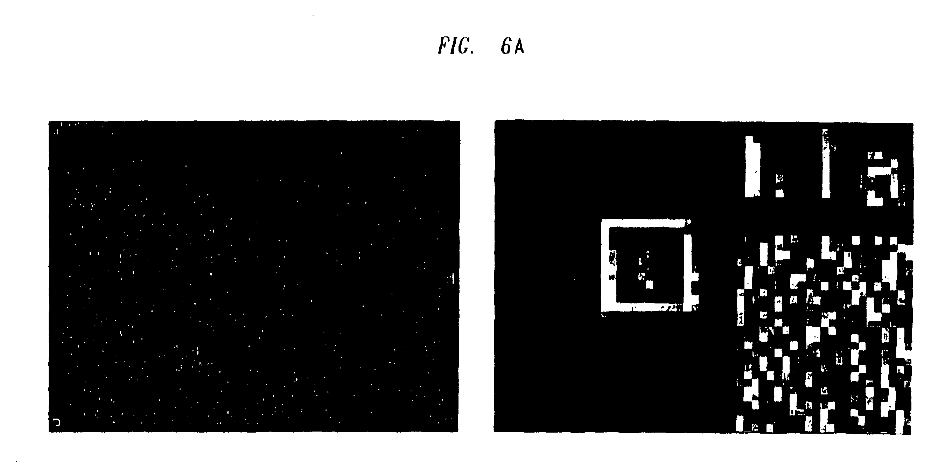

Thirteen weak holograms (diffraction efficiencies less than 0.01%) were angularly multiplexed in the medium with the sample angle varying from -20° to 28° with an angular separation of 4°. After recording, the system was flood-cured with a xenon lamp filtered to transmit light of wavelength longer than 530 nm, to consume any remaining unreacted species. A thin film heater attached to the outer surface of the microscope slide that supported the sample allowed for controlled heating of the medium from 27°C to 55°C. The Bragg angles of the thirteen recorded holograms were measured at different temperatures by recording the diffracted intensity of one of the beams as a function of sample angle. The shifts in the Bragg angles (from the original recording positions) at 8 different temperatures are shown in Fig. 7.

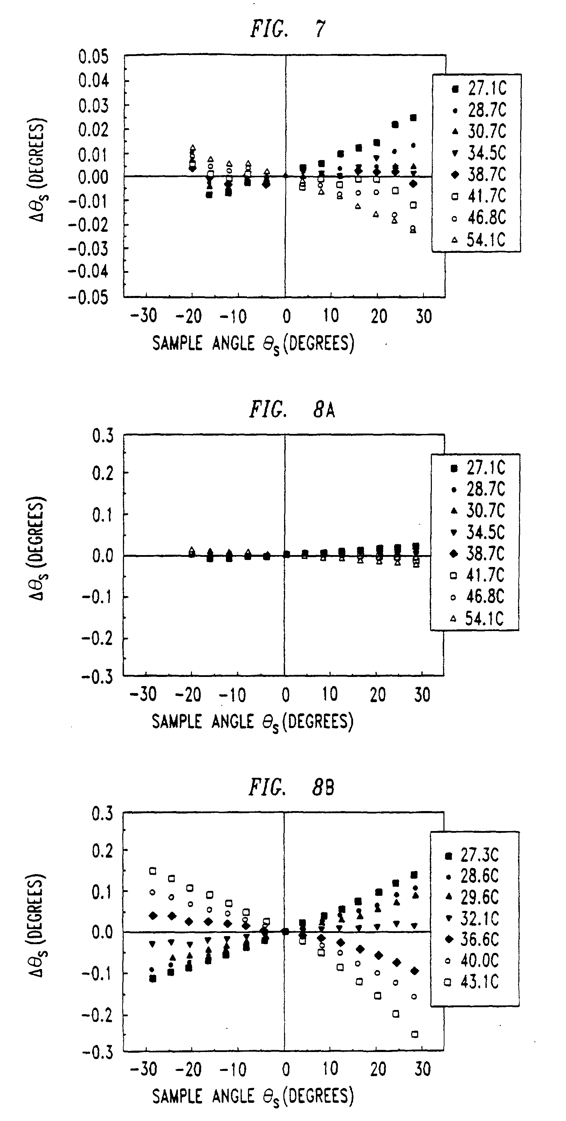

The temperature dependent Bragg shifts are at least an order of magnitude smaller than those of a thin layer of a conventional photopolymer system contained between two rigid glass substrates. (See, e.g., L. Dhar et al., "Temperature-induced changes in photopolymer volume holograms," supra.) Fig. 8A shows the same data of Fig. 7, but with a different scale for $\Delta\theta_s$, while Fig. 8B shows the temperature dependence of the Bragg shifts measured in conventional polymer media, as discussed in L. Dhar et al., "Temperature-induced changes in photopolymer volume holograms," supra. The medium of the invention allows a much greater temperature operating window than conventional photopolymer media.

Other embodiments of the invention will be apparent to those skilled in the art from consideration of the specification.

**Claims**

1. A process for holography, comprising the steps of:

   irradiating selected regions of a recording medium comprising a matrix having interconnected porosity, the matrix pores comprising a photoimageable system that comprises one or more photopolymerizable components, wherein the irradiation induces polymerization of the one or more photopolymerizable components, and wherein the matrix is a rigid matrix that exhibits an absolute Bragg shift of less than 0.1° for all plane-wave gratings with absolute grating tilt angles less than 25°, and
   fixing the recording medium subsequent to irradiation to react photopolymerizable components remaining after the irradiation, such that a readable hologram is formed in the absence of the removal of such remaining photopolymerizable components from the medium, the readable hologram capable of being non-destructively read by the same wavelength of light used for the irradiation.

2. The process of claim 1, wherein the matrix comprises about 10 to about 50 vol.% interconnected porosity.

3. The process of claim 1, wherein the matrix comprising the photoimageable system exhibits low light scattering, such that the Rayleigh ratio in 90° light scattering of the wavelength used for irradiation is less than about $7 \times 10^{-3}$, before and after the irradiation.

4. The process of claim 1, wherein the area of a surface of the matrix is at least 1 in$^2$.

5. The process of claim 1, wherein the matrix has a thickness of at least 200 μm.

6. The process of claim 5, wherein the matrix has a thickness of at least 500 μm.

7. The process of claim 1, wherein at least one photopolymerizable component is acrylate-based.

8. The process of claim 7, wherein the acrylate-based photopolymerizable component comprises a polyether backbone.

9. The process of claim 8, wherein the acrylate-based photopolymerizable component is poly(ethyleneglycol) oligomer diacrylate.

10. The process of claim 9, wherein the photoimageable system further comprises di(ethyleneglycol) ethyl ether acrylate monomer.

11. The process of claim 1, wherein multiple holograms are formed by the irradiation.

12. The process of claim 1, wherein the fixing step is performed by a flood cure.


**Patentansprüche**

1. Holographisches Verfahren, welches folgende Schritte umfasst:

   Bestrahlen ausgewählter Bereiche eines Aufzeichnungsmediums, das eine Matrix und eine mit dieser zusammenhängende Porosität umfasst, wobei die Poren der Matrix ein Photoabbildungssystem umfassen, das eine oder mehrere photopolymerisierbare Komponente(n) umfasst, wobei die Bestrahlung die Polymerisation der einen oder mehreren photopolymerisierbaren Komponente(n) herbeiführt, und wobei die Matrix eine feste Matrix ist, die eine absolute Bragg-Verschiebung von weniger als 0,1° für alle Gitter für ebene Wellen mit absoluten Gitterneigungswinkeln von weniger als 25° zeigt, und
   Fixieren des Aufzeichnungsmediums nach der Bestrahlung, um die nach der Bestrahlung verbleibenden photopolymerisierbaren Komponenten reagieren zu lassen, sodass ohne die Entfernung dieser verbleibenden photopolymerisierbaren Komponenten aus dem Medium ein lesbares Hologramm ausgebildet wird, wobei das lesbare Hologramm mittels derselben Lichtwellenlänge, die für die Bestrahlung verwendet worden ist, zerstörungsfrei gelesen werden kann.

2. Verfahren nach Anspruch 1, bei welchem die Matrix etwa 10 bis etwa 50 Volumenprozent untereinander verbundener Poren umfasst.

3. Verfahren nach Anspruch 1, bei welchem die Matrix,die das Photoabbildungssystem umfasst, eine geringe Lichtstreuung zeigt, sodass das Rayleigh-Verhältnis der für die Bestrahlung verwendeten Wellenlänge bei einer Lichtstreuung bei 90° vor und nach der Bestrahlung geringer als etwa $7 \times 10^{-3}$ ist.

4. Verfahren nach Anspruch 1, bei welchem der Flächeninhalt einer Oberfläche der Matrix wenigstens 1 Quadratzoll beträgt.

5. Verfahren nach Anspruch 1, bei welchem die Matrix eine Dicke von wenigstens 200 μm aufweist.

6. Verfahren nach Anspruch 5, bei welchem die Matrix eine Dicke von wenigstens 500 μm aufweist.

7. Verfahren nach Anspruch 1, bei welchem wenigstens eine photopolymerisierbare Komponente eine Komponente auf Acrylat-Basis ist.

8. Verfahren nach Anspruch 7, bei welchem die photopolymerisierbare Komponente auf Acrylat-Basis ein Polyether-Rückgrat umfasst.

9. Verfahren nach Anspruch 8, bei welchem die photopolymerisierbare Komponente auf Acrylat-Basis Poly(ethylenglycol)-oligomerdiacrylat ist.

10. Verfahren nach Anspruch 9, bei welchem das Photoabbildungssystem ferner ein Di(ethylenglycol)-ethylether-Acrylatmonomer umfasst.

11. Verfahren nach Anspruch 1, bei welchem durch die Bestrahlung mehrfache Hologramme ausgebildet werden.

12. Verfahren nach Anspruch 1, bei welchem der Fixierschritt durch eine Lichtflutungsaushärtung erfolgt.

**Revendications**

1. Procédé d'holographie comprenant les stades de :

   exposition de zones sélectionnées d'un support d'enregistrement comprenant une matrice ayant une porosité interconnectée, les pores de la matrice comprenant un système photoimageable qui comprend un constituant photopolymérisable ou plusieurs constituants photopolymérisables, l'exposition induisant une polymérisation du constituant photopolymérisable ou des plusieurs constituants photopolymérisables, et la matrice est une matrice rigide qui présente un décalage absolu de Bragg inférieur à 0,1° pour tous les réseaux d'onde plane ayant des angles d'incidence absolue de réseau inférieurs à 25°, et
   fixation du support d'enregistrement après exposition, pour faire réagir les constituants photopolymérisables restant après l'exposition, de façon à former un hologramme qui peut être lu, en l'absence de l'élimination de constituants photopolymérisables restants de ce genre du support, l'hologramme qui peut être lu pouvant être lu d'une manière non destructive par la même longueur d'onde de lumière que celle utilisée pour l'exposition.

2. Procédé suivant la revendication 1, dans lequel la matrice comprend environ 10 à 50 % en volume de porosité interconnectée.

3. Procédé suivant la revendication 1, dans lequel la matrice comprenant le système photoimageable a une faible diffusion de la lumière, de sorte que le rapport Rayleigh pour la diffusion de la lumière à 90° de la longueur d'onde utilisée pour l'exposition est inférieur à environ $7 \times 10^{-3}$, avant et après l'exposition.

4. Procédé suivant la revendication 1, dans lequel l'aire d'une surface de la matrice est d'au moins 1 pouce$^2$ (25,6 mm x 25,6mm).

5. Procédé suivant la revendication 1, dans lequel la matrice a une épaisseur d'au moins 200 µm.

6. Procédé suivant la revendication 5, dans lequel la matrice a une épaisseur d'au moins 500 µm.

7. Procédé suivant la revendication 1, dans lequel au moins un constituant photopolymérisable est à base d'acrylate.

8. Procédé suivant la revendication 7, dans lequel le constituant photopolymérisable à base d'acrylate comprend un squelette polyetheroxyde.

9. Procédé suivant la revendication 8, dans lequel le constituant polymérisable à base d'acrylate est du poly(éthylèneglycol)oligomèrediacrylate.

10. Procédé suivant la revendication 9, dans lequel le système photoimageable comprend en outre un di(éthylèneglycol)éthyl-oxyde-acrylate monomère.

11. Procédé suivant la revendication 1, dans lequel des hologrammes multiples sont formés par l'exposition.

12. Procédé suivant la revendication 1, dans lequel le stade de fixation est effectué par durcissement sous l'action d'un faisceau.

*FIG. 1*

*FIG. 2*

FIG. 3A

FIG. 3B

FIG. 4

## FIG. 5

## FIG. 6B

FIG. 6A

FIG. 7

FIG. 8A

FIG. 8B